(19) Europäisches Patentamt

European Patent Office

Office européen des brevets

(11) EP 0 442 492 B1

(12) EUROPEAN PATENT SPECIFICATION

(45) Date of publication and mention
of the grant of the patent:
18.12.1996 Bulletin 1996/51

(51) Int Cl.⁶: H03H 11/04

(21) Application number: 91102092.3

(22) Date of filing: 14.02.1991

(54) **Active filter**

Aktiver Filter

Filtre actif

(84) Designated Contracting States:
DE FR GB

(30) Priority: 14.02.1990 JP 32699/90

(43) Date of publication of application:
21.08.1991 Bulletin 1991/34

(73) Proprietor: KABUSHIKI KAISHA TOSHIBA
Kawasaki-shi, Kanagawa-ken 210 (JP)

(72) Inventor: Hagino, Hideyuki,
c/o Intellectual Property Div.
Minato-ku, Tokyo 105 (JP)

(74) Representative: Lehn, Werner, Dipl.-Ing. et al
Hoffmann, Eitle & Partner,
Patentanwälte,
Postfach 81 04 20
81904 München (DE)

(56) References cited:
DE-A- 3 830 410          US-A- 4 292 468

• PATENT ABSTRACTS OF JAPAN vol. 11, no. 61
(E-483)(2508) 25 February 1987 & JP-A-61 220
517

**Description**

The present invention relates to an active filter comprising a current differential amplifier (11) having an inverting input terminal, a non-inverting input terminal and an output terminal and supplied with an input signal at the non-inverting input terminal; a capacitor ($C_0$) connected between the output terminal of said current differential amplifier (11) and a power source ($V_{SS}$) for storing charges according to an output signal of said current differential amplifier (11); and an adding circuit (12) for adding the input signal and the output signal of said current differential amplifier (11) and for supplying an output signal to an output terminal of said filter and to the inverting input terminal of said current differential amplifier (11).

Such active filter is disclosed in Patent Abstracts of Japan, vol. 11, No. 61 (E-483) (2508), 25 February 1987 and JP-A-61 220 517.

In addition to the components mentioned above this prior art active filter requires, in addition to resistors and a capacitor, a voltage/current converting circuit, an operational amplifier, a coefficient circuit, and a multiplier circuit. These active circuits and the operational amplifier are each made up of a large number of transistors, resulting in that the prior art active filter circuit configuration is complex, and the manufacturing costs thereof are inevitably high.

DE-A-38 30 410 discloses an active filter signal adjustment circuit comprising an input and an output unit, first and second operational amplifiers, a buffer amplifier, first and second adding units, and first and second capacitor units.

The problem to be solved by the present invention is to provide an active filter which is simpler in circuit configuration than the prior art and can be manufactured at low costs.

The problem is solved by an active filter having the features indicated in independent claim 1. According to a preferred embodiment of the invention indicated in dependent claim 2, the power source is a ground potential.

For facilitating to understand the present invention the technical background thereof will be briefly outlined hereinafter.

An active filter is known as a filter whose size and weight can be easily reduced. The active filter is a circuit formed of a combination of an operation amplifier, resistor element and capacitor element.

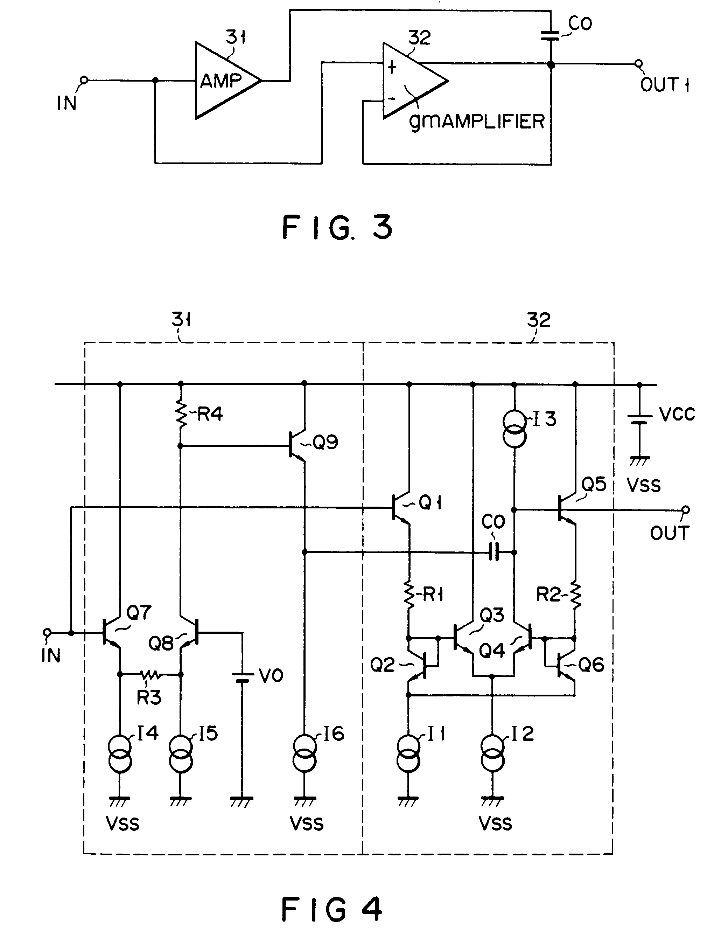

Fig. 3 is an equivalent circuit diagram showing the construction of a conventional active filter. An input terminal IN is connected to the input terminal of an amplifier 31 and the non-inverting input terminal of a current differential amplifier (which is hereinafter referred to as a gm amplifier) 32. The output terminal of the amplifier 31 is connected to an output terminal of the gm amplifier 32 and an output terminal OUT via a capacitor Co. Further, the output terminal of the gm anplifier 32 is connected to the inverting input terminal of the gm amplifier 32.

Fig. 4 is a circuit diagram showing the concrete construction of the above equivalent circuit and an area surrounded by broken lines on the left hand side indicates the amplifier 31 and an area on the right hand side indicates the gm amplifier 32.

In the amplifier 31, the base of a transistor $Q_7$ is connected to the input terminal IN. The collector of the transistor $Q_7$ is connected to a power source Vcc and the emitter thereof is connected to the emitter of a transistor $Q_8$ via a resistor $R_3$ and to the ground potential Vss via a constant current source $I_4$. The emitter of the transistor $Q_8$ is connected to the ground potential Vss via a constant current source $I_5$ and the base thereof is connected to the ground potential Vss via a reference power source Vo. Further, the collector of the transistor $Q_8$ is connected to the power source Vcc via a resistor $R_4$ and to the base of a transistor $Q_9$. The collector of the transistor $Q_9$ is connected to the power source Vcc and the emitter thereof is connected to the ground potential Vss via a constant current source $I_6$.

In the gm amplifier 32, the base of a transistor $Q_1$ is connected to the input terminal IN. The collector of the transistor $Q_1$ is connected to the power source Vcc and the emitter thereof is connected to the collector and base of a transistor $Q_2$ via a resistor R1 and to the base of a transistor $Q_3$ via a resistor R1. The emitter of the transistor $Q_2$ is connected to the ground potential Vss via a constant current source $I_1$ and to the emitter of a transistor $Q_6$. The collector of the transistor $Q_3$ is connected to the power source Vcc and the emitter thereof is connected to the emitter of a transistor $Q_4$ and to the ground potential Vss via a constant current source $I_2$. The collector of the transistor $Q_4$ is connected to the emitter of the transistor $Q_9$ of the amplifier 31 via the capacitor Co and to the power source Vcc via a constant current source $I_3$. Further, the collector of the transistor $Q_4$ is connected to the base of a transistor $Q_5$ and to the output terminal OUT. The collector of the transistor $Q_5$ is connected to the power source Vcc and the emitter thereof is connected to the collector and base of the transistor $Q_6$ via a resistor $R_2$ and to the base of the transistor $Q_3$ via a resistor R2.

With the above construction, a signal voltage supplied to the input terminal IN is converted into current by means of the gm amplifier 32 and the capacitor Co is charged or discharged by the converted current. At the same time, the capacitor Co is applied with a voltage corresponding to a signal voltage supplied to the input terminal IN via the amplifier 31. As a result, a voltage obtained by adding a voltage output from the amplifier 31 to the charged voltage of the capacitor Co is output from the output terminal OUT.

That is, the signal voltage supplied from the input terminal IN is applied to the base of the NPN transistor $Q_1$ serving as the non-inverting input terminal of the gm amplifier 32 and to the base of the NPN transistor $Q_7$ serving as the input terminal of the amplifier 31. Current flowing in the collector-emitter path of the transistor $Q_1$ permits the transistor $Q_2$

to be turned on via the resistor $R_1$ and permits the transistor $Q_3$ which is one of two transistors constituting the differential pair to be turned on. Further, since the transistor $Q_5$ is always kept in the conductive state by means of the constant current source $I_3$, the transistor $Q_6$ is turned on by current flowing in the resistor $R_2$ and the transistor $Q_4$ which is the other of the two transistors constituting the differential pair is also turned on. The capacitor Co connected to the collector of the transistor $Q_4$ is charged or discharged by a current difference between the collector currents of the transistors $Q_3$ and $Q_4$ and an output signal can be derived from the output terminal OUT. Further, the output signal is fed back to the inverting input terminal of the gm amplifier 32.

In the amplifier 31, the transistor $Q_8$ is biased by the reference voltage Vo and is always kept in the on state and the transistor $Q_9$ is biased by current flowing in the resistor $R_4$ and is turned on. If a signal is input to the input terminal IN in this state, the transistor $Q_7$ is turned on. Since the resistor $R_3$ is connected between the emitters of the transistors $Q_7$ and $Q_8$, the current flowing in the transistor $Q_8$ may be varied by means of the resistor $R_3$ when the emitter current of the transistor $Q_7$ is changed according to the input signal. The operation of the transistor $Q_9$ biased by the resistor $R_4$ is controlled according to variation in the emitter current of the transistor $Q_8$. An amount of charges stored in the capacitor Co varies with variation in the emitter current of the transistor $Q_9$.

In practice, a signal which is obtained by converting a voltage into current by means of the gm amplifier 32 may affect not only the capacitor Co but also the output terminal of the amplifier 31 via the emitter resistor $r_9$ (not shown) of the transistor $Q_9$. As a result, a signal output from the output terminal OUT deviates from a theoretical value. Further, in a case where the capacitor Co is charged according to a signal voltage supplied to the input terminal IN and the charged voltage is added to the signal obtained by converting the voltage into the current, the signal may be made unstable by the emitter resistor $r_9$ of the transistor $Q_9$ and the collector impedance Ro of the transistor $Q_4$.

In order to explain the above defects, the transfer function of the circuit having the construction shown in Fig. 4 is shown by the following equation. In this case, the emitter resistor of each transistor Qn is indicated by $r_n$ (n=7, 8, 9) and the collector impedance of the transistor $Q_4$ is indicated by Ro. Further, if the conductance of the gm amplifier is denoted by gmo, the input voltage is denoted by Vin and the output voltage is denoted by Vout, then the relation between them can be expressed by the following equation.

$$Vout = \frac{r_9 + (1/j\omega Co)}{gmo} (Vin-Vout) + \frac{R_4}{r_7 + r_8 + R_3} \cdot$$

$$\frac{Ro}{Ro + r_9 + (1/j\omega Co)} \cdot Vin \qquad (1)$$

The above equation (1) can be rewritten as follows:

$$(1 + \frac{1 + j\omega Cor_9}{j\omega Cogmo}) Vout = (\frac{1 + j\omega Cor_9}{j\omega Cogmo} + \frac{R_4}{r_7 + r_8 + R_3}$$

$$\times \frac{j\omega CoRo}{1 + (Ro+R_9)j\omega Co}) Vin \qquad (2)$$

If $1/j\omega Cogmo = n/s$, $R_4/(r_7 + r_8 + R_3) = m$,
$R_9/gmo = a$, and $j\omega CoRo/\{1 + (Ro + r_9)j\omega Co\} = b$, then the equation (2) can be rewritten as follows:

$$(1 + \frac{n}{s} + a) Vout = (a + \frac{n}{s} + mb) Vin \qquad (3)$$

In this case, the transfer function Vout/Vin can be expressed as follows:

$$Vout/Vin = \frac{n + (a + mb)s}{n + (1 + a)s} \doteqdot \frac{n + ms}{n + s}$$

$$(where\ a = 0\ and\ b = 1) \qquad (4)$$

As shown in the above equation (4), the signal becomes equal to the theoretical value only when a=0 and b=1, and this condition is satisfied when the emitter resistor $r_9$ of the transistor $Q_9$ in Fig. 4 is neglected and the collector impedance of the transistor $Q_4$ is regarded as being infinite.

As has been described, in the conventional active filter, the amplifier 31 is connected to the gm amplifier 31 by means of the capacitor Co. The amplifiers 31 and 32 inevitably interfere with each other. Consequently, the magnitude of the signal output by the active filter deviates from the theoretical value.

An advantage of this invention is to provide an active filter capable of deriving an output signal which is equal to the theoretical value.

This invention can be more fully understood from the following detailed description when taken in conjunction with the accompanying drawings, in which:

Fig. 1 is an equivalent circuit diagram of the construction according to one embodiment of this invention;
Fig. 2 is a circuit diagram showing the concrete construction of the circuit shown in Fig. 1;
Fig. 3 is an equivalent circuit diagram showing the construction of the conventional active filter; and
Fig. 4 is a circuit diagram showing the concrete construction of the circuit shown in Fig. 3.

There will now be described an embodiment of this invention with reference to the accompanying drawings.

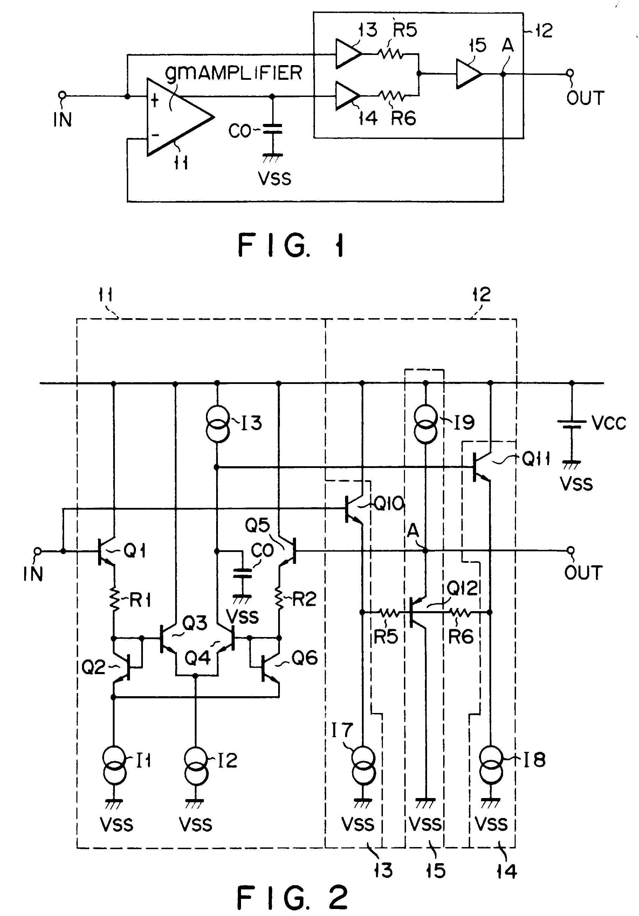

Fig. 1 is an equivalent circuit diagram showing the construction according to one embodiment of an active filter of this invention and shows a high-pass filter (HPF) or rig type high-pass filter.

An input terminal IN is connected to the non-inverting input terminal of a current differential amplifier (gm amplifier) 11 and to the input terminal of a first buffer circuit 13. The output terminal of the gm amplifier 11 is connected to the ground potential Vss via a capacitor Co and to the input terminal of a second buffer circuit 14. The output terminals of the buffer circuits 13 and 14 are connected to the input terminal of a third buffer circuit 15 via first and second resistors $R_5$ and $R_6$, respectively. The output terminal of the buffer circuit 15 is connected to the output terminal OUT and to the inverting input terminal of the gm amplifier 11.

Fig. 2 is a circuit diagram showing the concrete construction of the circuit shown in Fig. 1, and portions which are the same as those of Fig. 1 are denoted by the same reference numerals.

In the gm amplifier 11, the base of an NPN transistor $Q_1$ serving as the non-inverting input terminal is connected to the input terminal IN. The collector of the transistor $Q_1$ is connected to the power source Vcc, and the emitter thereof is connected to the base and collector of an NPN transistor $Q_2$ via a resistor R1 and to the base of an NPN transistor $Q_3$ via this resistor R1. The emitter of the transistor $Q_2$ is connected to the ground potential Vss via a constant current source $I_1$. The collector of the transistor $Q_3$ is connected to the power source Vcc and the emitter thereof is connected to the emitter of a transistor $Q_4$ and to the ground potential Vss via a constant current source $I_2$. The collector of the transistor $Q_4$ is connected to the ground potential Vss via the capacitor Co and to the power source Vcc via a constant current source $I_3$ and the base thereof is connected to the base and collector of a transistor $Q_6$. The emitter of the transistor $Q_6$ is connected to the emitter of the transistor $Q_2$ and the collector thereof is connected to the emitter of an NPN transistor $Q_5$ via the resistor $R_2$. The base of the transistor $Q_5$ is used as the inverting input terminal of the gm amplifier 11 and is connected to the output terminal OUT. The collector of the transistor $Q_5$ is connected to the power source Vcc.

In an adding circuit 12, the base of an NPN transistor $Q_{10}$ constituting the first buffer circuit 13 is connected to the input terminal IN. The collector of the transistor $Q_{10}$ is connected to the power source Vcc and the emitter thereof is connected to the ground potential Vss via a constant current source $I_7$ and to the base of a transistor $Q_{12}$ constituting the third buffer circuit 15 via the resistor $R_5$. The collector of the transistor $Q_{12}$ is connected to the ground potential Vss and the emitter thereof is connected to the output terminal OUT and to the power source Vcc via a constant current source $I_9$. Further, the base of a transistor $Q_{11}$ constituting the second buffer circuit 14 is connected to the collector of the transistor $Q_4$ and the collector thereof is connected to the power source Vcc. The emitter of the transistor $Q_{11}$ is connected to the base of the transistor $Q_{12}$ via the resistor $R_6$ and to the ground potential Vss via a constant current source $I_8$.

Now, the operation of the circuit with the above construction is explained.

The base of the transistor $Q_5$ in the gm amplifier 11 is supplied with current fed back from the output terminal A of the buffer circuit 15. The current flowing in the collector-emitter path of the transistor $Q_5$ turns on the transistor $Q_6$ via the resistor $R_2$, thereby causing the transistor $Q_4$ which is one of the two transistors constituting the differential pair to be turned on.

A signal voltage supplied to the input terminal IN is applied to the base of the transistor $Q_1$ and the base of the transistor $Q_{10}$ constituting the buffer circuit 13. The current flowing in the collector-emitter path of the transistor $Q_1$ causes the transistor $Q_2$ to be turned on via the resistor $R_1$, thus causing the transistor $Q_3$ which is one of the two transistors constituting the differential pair to be turned on. As a result, charges of an amount corresponding to a difference between the collector currents of the transistors $Q_3$ and $Q_4$ are stored in the capacitor Co.

The emitter current of the transistor $Q_{10}$ which is turned on by the signal voltage supplied to the input terminal IN and the emitter current of the transistor $Q_{11}$ which is turned on by an output of the gm amplifier 11 are supplied to the base in the buffer circuit 15 via the resistors $R_5$ and $R_6$, respectively, so as to turn on the transistor $Q_{12}$. That is, a

signal output from the gm amplifier 11 and a signal voltage from the input term,trial IN are added together at a rate corresponding to the dividing ratio of the resistors $R_6$ and $R_5$. As a result, a signal obtained by adding a signal of a given level to the signal which is converted into the current form is output from the output terminal OUT.

According to the above embodiment, one end of the capacitor Co is grounded and it does not connect the gm amplifier 11 and adding circuit 12 to each other. Therefore, the capacitor Co will not affect the theoretical value of a signal output from the output terminal OUT and will not affect a feedback signal supplied to the inverting input terminal of the gm amplifier 11.

Next, the transfer function of the circuit in this embodiment is explained. In this case, if the load resistance in each of the transistors Qn (n = 1 to 6 and 10 to 12) is denoted by $r_n$ (n = 1 to 6 and 10 to 12), the conductance gm of the gm amplifier 11 is denoted by gmo, the input voltage is denoted by Vin, and the output voltage is denoted by Vout, then the relation of these factors can be expressed by the following equation.

$$Vout = \frac{1/j\omega Co}{gmo} (Vin - Vout)$$

$$+ \frac{1/j\omega Co}{gmo} (Vin - Vout) \cdot \frac{r_{10} + R_5}{r_{10} + r_{11} + R_5 + R_6}$$

$$+ \frac{r_{11} + R_6}{r_{10} + r_{11} + R_5} \cdot Vin \tag{5}$$

In this case, if $1/j\omega Cogmo = n_1/s$ and
$(r_{10} + R_5)/(r_{10} + r_{11} + R_5 + R_6) = m_1$, then the equation (5) can be rewritten as follows:

$$(1 + \frac{n_1}{s} + \frac{n_1}{s} m_1) Vout = (\frac{n_1}{s} + \frac{n_1}{s} m_1 + 1 - m_1) Vin \tag{6}$$

Further, the transfer function Vout/Vin can be expressed by the following equation:

$$Vout/Vin = \frac{n_1 + (1 + m_1) + (1 - m_1)s}{n_1 (1 + m_1) + s} \tag{7}$$

In this case, if $1 + m_1 = m$ and $n_1(1 + m_1) = n$, then the equation (7) can be rewritten as follows:

$$\frac{Vout}{Vin} = \frac{n + ms}{n + s} \tag{8}$$

As shown by the equation (7), according to this embodiment, an active filter in which an output equal to the theoretical value can be derived can be obtained.

The gm amplifier, buffer circuit and the like in the circuit of the above embodiment are not limited to those shown in the above embodiment and various modifications can be made.

Further, in the above embodiment, the capacitor Co is connected between the collector of the transistor $Q_4$ and the ground potential Vss, but it can be connected between the collectors of the transistors $Q_3$ and $Q_4$, for example, so as to attain the same effect of the above embodiment.

## Claims

1. An active filter comprising:

   a current differential amplifier (11) having an inverting input terminal, a non-inverting input terminal and an output terminal and supplied with an input signal at the non-inverting input terminal;

   a capacitor (Co) connected between the output terminal of said current differential amplifier (11) and a power source ($V_{SS}$) for storing charges according to an output signal of said current differential amplifier (11); and

EP 0 442 492 B1

an adding circuit (12) for adding the input signal and the output signal of said current differential amplifier (11) and for supplying an output signal to an output terminal of said filter and to the inverting input terminal of said current differential amplifier (11);

**characterized** in that

said adding circuit (12) comprises:
first and second resistors ($R_5$, $R_6$) for adding the input signal and the output signal of said current differential amplifier (11) at a rate corresponding to the dividing ratio of said resistors ($R_5$, $R_6$);

and said adding circuit (12) further comprises:
a first buffer circuit (13) having an input terminal connected to the non-inverting input terminal of said current differential amplifier (11);

the first resistor ($R_5$) being connected at one end thereof to an output terminal of said first buffer circuit (13);

a second buffer circuit (14) having an input terminal connected to the output terminal of said current differential amplifier (11);

the second resistor ($R_6$) being connected at one end thereof to an output terminal of said second buffer circuit (14); and

a third buffer circuit (15) having an input terminal connected to the other end of said first and second resistors ($R_5$, $R_6$) and an output terminal connected to the output terminal of said filter and to the inverting input terminal of said current differential amplifier (11).

2. An active filter according to claim 1, characterized in that said power source is a ground potential ($V_{SS}$).

**Patentansprüche**

1. Aktives Filter mit:

einem Stromdifferenzverstärker (11), der eine invertierende Eingangsklemme, eine nicht-invertierende Eingangsklemme und eine Ausgangsklemme aufweist, und dem ein Eingangssignal an der nicht-invertierenden Eingangsklemme zugeführt wird;

einem Kondensator (C0), der zwischen die Ausgangsklemme des Stromdifferenzverstärkers (11) und eine Spannungsquelle (VSS) geschaltet ist, um Ladungen entsprechend einem Ausgangssignal des Stromdifferenzverstärkers (11) zu speichern; und

einer Addierschaltung (12) zum Addieren des Eingangssignals und des Ausgangssignals des Stromdifferenzverstärkers (11), und zum Liefern eines Ausgangssignals an eine Ausgangsklemme des Filters sowie an die invertierende Eingangsklemme des Stromdifferenzverstärkers (11);

dadurch **gekennzeichnet**, daß

die Addierschaltung (12) aufweist:
einen ersten und einen zweiten Widerstand (R5, R6) zum Addieren des Eingangssignals und des Ausgangssignals des Stromdifferenzverstärkers (11) mit einer Rate entsprechend dem Teilerverhältnis der Widerstände (R5, R6);

und die Addierschaltung (12) weiterhin aufweist:
eine erste Pufferschaltung (13), die eine an die nicht-invertierende Eingangsklemme des Stromdifferenzverstärkers (11) angeschlossene Eingangsklemme aufweist;

den ersten Widerstand (R5), der an seinem einen Ende an einer Ausgangsklemme der ersten Pufferschaltung (13) angeschlossen ist;

6

eine zweite Pufferschaltung (14), die eine Eingangsklemme aufweist, die an die Ausgangsklemme des Stromdifferenzverstärkers (11) angeschlossen ist;

den zweiten Widerstand (R6), der an seinem einen Ende an eine Ausgangsklemme der zweiten Pufferschaltung (14) angeschlossen ist; und

eine dritte Pufferschaltung (15), die eine Eingangsklemme aufweist, die mit dem anderen Ende des ersten und zweiten Widerstands (R5, R6) verbunden ist, sowie eine Ausgangsklemme, die an die Ausgangsklemme des Filters und an die invertierende Eingangsklemme des Stromdifferenzverstärkers (11) angeschlossen ist.

2.  Aktives Filter nach Anspruch 1,
    dadurch **gekennzeichnet**, daß die Spannungsquelle ein Massepotential (VSS) ist.

**Revendications**

1.  Filtre actif, comprenant:

    -   un amplificateur différentiel de courant (11) ayant une borne d'entrée inverseuse, une borne d'entrée non inverseuse et une borne de sortie, et recevant un signal d'entrée à la borne d'entrée non inverseuse;
    -   un condensateur Co monté entre la borne de sortie dudit amplificateur différentiel de courant (11) et une source d'énergie (Vss) pour stocker des charges selon le signal de sortie dudit amplificateur différentiel de courant (11); et
    -   un circuit additionneur (12) pour additionner le signal d'entrée et le signal de sortie dudit amplificateur différentiel de courant (11) et pour fournir un signal de sortie à une borne de sortie dudit filtre et à la borne d'entrée inverseuse dudit amplificateur différentiel de courant (11),

        caractérisé en ce que:

    ledit circuit additionneur (12) comprend:

    -   des première et deuxième résistances (R5, R6) pour additionner le signal d'entrée et le signal de sortie dudit amplificateur différentiel de courant (11) dans une proportion correspondant au rapport de division desdites résistances (R5, R6);

    et ledit circuit additionneur (12) comprend en outre:

    -   un premier circuit tampon (13) ayant une borne d'entrée connectée à la borne d'entrée non inverseuse dudit amplificateur différentiel de courant (11),
        la première résistance (R5) étant connectée par une extrémité de celle-ci à la borne de sortie dudit premier circuit tampon (13);
    -   un deuxième circuit tampon (14) ayant une borne d'entrée connectée à la borne de sortie dudit amplificateur différentiel de courant (11),
        la deuxième résistance (R6) étant connectée par une extrémité de celle-ci à la borne de sortie dudit deuxième circuit tampon (14); et
    -   un troisième circuit tampon (15) ayant une borne d'entrée connectée à l'autre extrémité desdites première et deuxième résistances (R5, R6) et une borne de sortie connectée à la borne de sortie dudit filtre et à la borne d'entrée inverseuse dudit amplificateur différentiel de courant (11).

2.  Filtre actif selon la revendication 1, caractérisé en ce que ladite source d'énergie est le potentiel de la masse (Vss).

F I G. 1

F I G. 2

8

F I G. 3

F I G 4